# EUROPEAN PATENT APPLICATION

(11) **EP 4 597 222 A1**
(43) Date of publication of application: **06.08.2025**
(21) Application number: 23871383.8
(22) Date of filing: 14.07.2023
(51) Int. Cl.: G03F 7/00, B41M 1/02, G03F 7/004, G03F 7/037

(54) **PHOTOSENSITIVE RESIN COMPOSITION FOR LETTERPRESS PRINTING ORIGINAL PLATE, LETTERPRESS PRINTING ORIGINAL PLATE, AND PRINTING PLATE**

(30) Priority: 26.09.2022 JP 2022153024
(71) Applicant: TOYOBO MC Corporation, Osaka 530-0001 (JP)
(72) Inventor: KAWASHIMA, Wataru, Okayama-shi, Okayama 704-8194 (JP); TANIGAWA, Masahito, Okayama-shi, Okayama 704-8194 (JP)
(74) Representative: Müller-Boré & Partner Patentanwälte PartG mbB
(86) International application number: PCT/JP2023/026009
(87) International publication number: WO 2024/070139

(57) **Abstract**

The present invention aims to provide: a photosensitive resin composition for a relief printing plate precursor, wherein the photosensitive resin composition is capable of reducing the change in developability of a relief printing plate precursor in a high-temperature environment, giving a resin relief printing plate that satisfies desired reproducibility in a high-temperature environment, and reducing printing failure at the time of printing performed with use of a resin relief printing plate in a low-temperature environment; a relief printing plate precursor; and a printing plate. A photosensitive resin composition for a relief printing plate precursor, wherein the photosensitive resin composition contains: a polyamide and/or a polyamide block copolymer (a); a crosslinking agent (b) having one or more unsaturated groups; a photopolymerization initiator (c); and polyglycerin and/or a polyglycerin derivative (d), wherein the polyglycerin derivative is obtained by addition polymerization of polyglycerin with ethylene oxide or propylene oxide, and wherein a content of (d) in the photosensitive resin composition is 3 to 15 wt%.

## Description

### Technical Field of the Invention

The present invention relates to a photosensitive resin composition for a relief printing plate precursor, a relief printing plate precursor, and a printing plate.

### Background Art

A photosensitive resin composition used for a printing plate precursor generally contains a soluble polymer compound, a photopolymerizable unsaturated compound, and a photopolymerization initiator, and also contains an additive such as a stabilizer and a plasticizer as necessary.

It is widely known that a relief plate for printing is made by a plate-making step comprising the steps of: applying an active light beam to a photosensitive resin layer obtained from a photosensitive resin composition through a negative film having a transparent image portion, so as to selectively cure the photosensitive resin layer; then dissolving and removing an uncured portion with an appropriate solvent; and drying and post-exposing the photosensitive resin layer having the uncured portion removed therefrom.

As to the soluble polymer compound, the use of a soluble polyamide, a completely or partially saponified polyvinyl acetate, or the like has been proposed.

Recently, users are increasingly requiring realization of ultrafine-pattern reproduction of a relief printing plate precursor. Specifically, as to a minimum highlight part of a developed printing plate, which part is used in printing of a picture, 5% or less dots at 150 lines are required to have reproducibility of smoothly changing brightness in a printing size close to the size of the negative (gradation expression of dots in a highlight part).

In order to deal with the requirement of the fine printability of dots in a highlight part, there are proposed, for example, a relief printing plate precursor having the image reproducibility improved by making a photosensitive resin layer have a structure formed of multiple layers having different light transmittances (see Patent Document 1), a relief printing plate precursor having a sharp relief shape formed by making a photosensitive resin layer have multiple layers (see Patent Document 2), and a relief printing plate precursor containing, in a photosensitive resin layer, a polyamide obtained by copolymerizing an alicyclic dicarboxylic acid and an alicyclic diamine (see Patent Document 3).

### Prior Art Documents

### Patent Documents

Patent Document 1: Japanese Patent Application Laid-Open (JP-A) No. 2002-23349
Patent Document 2: Japanese Patent Application Laid-Open (JP-A) No. 313966/94
Patent Document 3: WO2017/056692

### Disclosure of the Invention

### Problem that the Invention is to Solve

The making of a printing plate (hereinafter, also referred to as a rein relief printing plate) from a relief printing plate precursor obtained from a photosensitive resin composition for a relief printing plate precursor, and the printing with use of the resin relief printing plate are performed under various environments around the world. In a high-temperature environment, the developability of a relief printing plate precursor is sometimes changed. In a lower-temperature environment, the resin relief printing plate is sometimes poorly wound around a plate cylinder or causes a crack on a printing surface of a surface layer at the time of printing, leading to printing failure.

The present invention has been made in view of the circumstances described above. An object of the present invention is to provide: a photosensitive resin composition for a relief printing plate precursor, wherein the photosensitive resin composition is capable of reducing the change in developability of a relief printing plate precursor in a high-temperature environment, giving a resin relief printing plate that satisfies desired reproducibility in a high-temperature environment, and reducing printing failure at the time of printing performed with use of a resin relief printing plate in a low-temperature environment; a relief printing plate precursor; and a printing plate.

### Means for Solving the Problem

In order to achieve the object, the inventors of the present invention have found that by blending polyglycerin and/or a polyglycerin derivative in a photosensitive resin composition used for a relief printing plate precursor, a photosensitive resin composition capable of providing a plate having high environment adaptability can be obtained. The present invention has thus been completed.

That is, the present invention can encompass the following aspects of the invention.
[1] A photosensitive resin composition for a relief printing plate precursor, wherein the photosensitive resin composition contains: a polyamide and/or a polyamide block copolymer (a); a crosslinking agent (b) having one or more unsaturated groups; a photopolymerization initiator (c); and polyglycerin and/or a polyglycerin derivative (d), wherein the polyglycerin derivative is obtained by addition polymerization of polyglycerin with ethylene oxide or propylene oxide, and wherein a content of (d) in the photosensitive resin composition is 3 to 15 wt%.
[2] The photosensitive resin composition for a relief printing plate precursor according to [1], wherein the polyglycerin and the polyglycerin derivative (d) each have a number average molecular weight of 300 or more.
[3] The photosensitive resin composition for a relief printing plate precursor according to [1], wherein the photosensitive resin composition contains the polyglycerin derivative (d), and wherein the polyglycerin derivative (d) is polyoxyethylene polyglyceryl ether and/or polyoxypropylene polyglyceryl ether having a number average molecular weight of 300 or more.
[4] The photosensitive resin composition for a relief printing plate precursor according to any of [1] to [3], wherein the photosensitive resin composition contains: 40 to 60 wt% of the polyamide and/or the polyamide block copolymer (a); 20 to 50 wt% of the crosslinking agent (b) having one or more unsaturated groups; and 0.1 to 10 wt% of the photopolymerization initiator (c), and wherein the polyamide and/or the polyamide block copolymer (a) contains, in a molecule thereof, 20 wt% or more of blocks of structural units each containing an amide bond.
[5] A relief printing plate precursor obtained by stacking, on a support, a photosensitive resin layer made from the photosensitive resin composition for a relief printing plate precursor according to any of [1] to [4].
[6] A printing plate obtained by removing an uncured portion of the photosensitive resin layer from the relief printing plate precursor according to [5].

### Advantages of the Invention

The present invention can, by adding to a photosensitive resin composition polyglycerin and/or a polyglycerin derivative having flexibility, reduce the change in developability of a relief printing plate precursor in a high-temperature environment, give a resin relief printing plate that satisfies desired reproducibility in a high-temperature environment, and reduce printing failure at the time of printing performed with use of a resin relief printing plate in a low-temperature environment.

### Mode for Carrying Out the Invention

Hereinafter, the photosensitive resin composition for a relief printing plate precursor according to the present invention is described in detail.

A relief printing plate precursor comprises a photosensitive resin layer made from the photosensitive resin composition, an adhesive layer, and a support. In the present description, the numerical range represented by "to" means a range comprising the numerical values described before and after "to" as the lower-limit value and the upper-limit value.

As to the support, a material that is flexible but has excellent dimensional stability is preferred. Examples of the support include a support made from a metal such as steel, aluminum, copper, and nickel, and thermoplastic resin supports such as a polyethylene terephthalate film, a polyethylene naphthalate film, a polybutylene terephthalate film, and a polycarbonate film. Among these examples, a polyethylene terephthalate film is particularly preferred because it has excellent dimensional stability and sufficiently high viscoelasticity. The support preferably has a thickness of 50 to 350 µm, more preferably has a thickness of 100 to 250 µm in terms of, for example, mechanical characteristics, shape stability, and/or handleability at the time of making a printing plate.

The adhesive layer is disposed between the support and the photosensitive resin layer, and improves the adhesiveness between the support and the photosensitive resin layer. The adhesive layer may be formed of one layer or a plurality of layers. The adhesive layer preferably contains, for example, a binder component and a pigment and further contains a levelling agent and a curing agent.

Examples of the binder component include a polyester resin, an epoxy resin, a polyamide resin, a polyimide resin, a phenolic resin, a butadiene resin, a polyurethane resin, and a polystyrene-polyisoprene copolymer resin. These resins can be used singly or in mixture. Among these examples, particularly preferable binder components are a polyester resin and a polyurethane resin in terms of solvent resistance.

The photosensitive resin layer is made from a photosensitive resin composition. The photosensitive resin composition contains: a polyamide and/or a polyamide block copolymer (a); a crosslinking agent (b) having one or more unsaturated groups; a photopolymerization initiator (c); and polyglycerin and/or a polyglycerin derivative (d). The photosensitive resin composition may, in addition to the components (a) to (d), further contain other additives, e.g., a thermal polymerization inhibitor, a plasticizer, a dye, a pigment, a perfume, and/or an antioxidant.

The polyamide and/or the polyamide block copolymer (a) is a polymer compound containing, in a molecule thereof, 20 wt% or more, preferably 30 wt% or more of blocks of structural units each containing an amide bond. Examples of such a polymer compound include polyether amide, polyether ester amide, a tertiary nitrogen-containing polyamide, an ammonium salt-type tertiary nitrogen atom-containing polyamide, and an addition polymer of an amide compound having one or more amide bonds, with an organic diisocyanate compound. Among these examples, an ammonium salt-type tertiary nitrogen atom-containing polyamide is preferred. When a tertiary nitrogen atom-containing polyamide and an ammonium salt-type tertiary nitrogen atom-containing polyamide are contained, addition of an organic acid improves the developability. Examples of the organic acid include acetic acid, lactic acid, and a methacrylic acid, but the organic acid is not limited to these examples.

The polyamide block copolymer may have a urea bond and/or a urethane bond, in addition to the amide bond. Generally used UV ink contains a composition component similar to a composition component of a photosensitive resin composition used for a printing plate precursor. Therefore, the photosensitive resin layer has low UV ink resistance. However, by using, in the photosensitive resin layer, the polyamide and/or the polyamide block copolymer having an amide bond in a molecule thereof, it is possible to improve the UV ink resistance of the photosensitive resin layer. The proportion of the component (a) in the photosensitive resin composition is preferably 40 to 60 wt%. The polyamide block copolymer may contain a polyalkylene glycol so as to enable impartation of flexibility. Specific examples of the polyalkylene glycol include polyethylene glycol and a copolymer thereof.

Examples of the crosslinking agent (b) having one or more unsaturated group include an ethylene oxide addition product of dipentaerythritol, pentaerythritol, trimethylolpropane, glycerin, ethylene glycol, diethylene glycol, triethylene glycol, or phthalic acid; diglycidyl ether acrylic acid addition product of bisphenol A or bisphenol F; an addition reaction product of a polyvalent glycidyl ether with (meth)acrylic acid, such as ethylene glycol di(meth)acrylate, neopentyl glycol di(meth)acrylate, glycerol di(meth)acrylate, trimethylolpropane tri(meth)acrylate, pentaerythritol penta(meth)acrylate, and dipentaerythritol penta(meth)acrylate; a reaction addition product of a polyvalent carboxylic acid, such as adipic acid, with glycidyl (meth)acrylate; and an addition reaction product of a polyvalent amine, such as propylene diamine, with glycidyl (meth)acrylate. However, the crosslinking agent (b) is not limited to these examples. As to the component (b), not only a single compound, but also a mixture of two or more compounds can be used. The proportion of the component (b) in the photosensitive resin composition is preferably 20 to 50 wt%.

Examples of the photopolymerization initiator (c) include benzophenones, benzoins, acetophenones, benzyls, benzoin alkyl ethers, benzyl alkyl ketals, anthraquinones, and thioxanthones. Specific examples of the photopolymerization initiator (c) include benzophenone, chlorobenzophenone, benzoin, acetophenone, benzyl, benzoin methyl ether, benzoin ethyl ether, benzoin isopropyl ether, benzoin isobutyl ether, benzyl dimethyl ketal, benzyl diethyl ketal, benzyl diisopropyl ketal, anthraquinone, 2-ethylanthraquinone, 2-methylanthraquinone, 2-allylanthraquinone, 2-chloroanthraquinone, thioxanthone, and 2-chlorothioxanthone. The proportion of the component (c) in the photosensitive resin composition is preferably 0.1 to 10 wt%.

Regarding the component (d), the following explanation is established. The polyglycerin has a repeating structure containing an ether bond, and contributes to the resin relief printing plate maintaining the flexibility even in a low-temperature environment. The polyglycerin derivative is a compound obtained by addition polymerization of polyglycerin with ethylene oxide or propylene oxide, has, similarly to the polyglycerin, a repeating structure containing an ether bond, and contributes to the resin relief printing plate maintaining the flexibility even in a low-temperature environment. These effects are considered to be brought about, for example, by the nature that the polyglycerin and the polyglycerin derivative have a repeating structure containing an ether bond, and thereby easily undergo molecular motion and are less likely to be crystallized.

The polyglycerin and the polyglycerin derivative each preferably have a number average molecular weight of 300 or more and 3000 or less. The polyglycerin and the polyglycerin derivative each more preferably have a number average molecular weight of 350 or more, further preferably have a number average molecular weight of 500 or more, further preferably have a number average molecular weight of 700 or more. The polyglycerin and the polyglycerin derivative each more preferably have a number average molecular weight of 1500 or less, further preferably have a number average molecular weight of 1000 or less, further preferably have a number average molecular weight of 800 or less. The change in developability of the relief printing plate precursor stored in a high-temperature environment is increased according as the molecular weight is decreased. The reason therefor is considered to be as follows. When the molecular weight is low, the degree of the entanglement of the polyglycerin and the polyglycerin derivative is low. Such low degree of entanglement leads to increase of the mobility of the polyglycerin and the polyglycerin derivative. Accordingly, the photosensitive resin composition transfers to, for example, a more stable structure. On the other hand, the viscosity of the compound is increased according as the molecular weight is increased, and the dispersibility of the polyglycerin and the polyglycerin derivative in the photosensitive resin composition may possibly be lowered at the time of preparing the photosensitive resin composition. As to the number average molecular weight of each of the polyglycerin and the polyglycerin derivative, a range can be selected that comprises, as the lower limit and the upper limit, any two numerical values selected from 300, 350, 400, 500, 600, 700, 750, 800, 900, 1000, 1100, 1200, 1300, 1400, 1500, 1600, 1700, 1800, 1900, 2000, 2100, 2200, 2300, 2400, 2500, 2600, 2700, 2800, 2900, or 3000.

Specific examples of the polyglycerin derivative as the component (d) include polyoxyethylene(4) polyglyceryl ether, polyoxyethylene(6) polyglyceryl ether, polyoxyethylene(13) polyglyceryl ether, polyoxyethylene(20) polyglyceryl ether, polyoxyethylene(30) polyglyceryl ether, polyoxyethylene(40) polyglyceryl ether, polyoxypropylene(4) polyglyceryl ether, polyoxypropylene(9) polyglyceryl ether, polyoxypropylene(14) polyglyceryl ether, polyoxypropylene(18) polyglyceryl ether, and polyoxypropylene(24) polyglyceryl ether. However, the polyglycerin derivative is not limited to these examples. As to the polyglycerin derivative as the component (d), not only a single compound, but also a mixture of two or more compounds can be used.

The proportion of the component (d) in the photosensitive resin composition is preferably 3 to 15 wt%. When the proportion is less than 3 wt%, the resin relief printing plate cannot keep the flexibility in a low-temperature environment. This is because the contribution of the component (d) to plasticization of the resin relief printing plate becomes small. When the proportion is less than 3 wt%, the change in developability of the relief printing plate precursor stored in a high-temperature environment is large. This is considered to be because the mobility of the component (d) is increased as described above. When the proportion is more than 15 wt%, the dispersibility of the component (d) in the photosensitive resin composition is noticeably lowered. This is considered to be because the component (d) and the polymer are unevenly distributed. When the dispersibility of the component (d) in the photosensitive resin composition is lowered, the reproducibility of the resin relief printing plate developed from the relief printing plate precursor stored in a high-temperature environment can become lowered. The proportion of the component (d) in the photosensitive resin composition is more preferably 4 wt% or more, further preferably 5 wt% or more, further preferably 6 wt% or more. The proportion of the component (d) in the photosensitive resin composition is more preferably 12 wt% or less, further preferably 10 wt% or less, further preferably 8 wt% or less. As to the proportion of the component (d) in the photosensitive resin composition, a range can be selected that comprises, as the lower limit and the upper limit, any two numerical values selected from 3.0 wt%, 3.5 wt%, 4.0 wt%, 4.5 wt%, 5.0 wt%, 5.5 wt%, 6.0 wt%, 6.5 wt%, 7.0 wt%, 7.5 wt%, 8.0 wt%, 8.5 wt%, 9.0 wt%, 9.5 wt%, 10 wt%, 11 wt%, 12 wt%, 13 wt%, 14 wt% or 15 wt%.

The thermal polymerization inhibitor improves the thermal stability of the photosensitive resin layer. Examples of the thermal polymerization inhibitor include hydroquinones, benzoquinones, phenols, catechols, aromatic amine compounds, bicric acids, phenothiazine, α-naphthoquinones, anthraquinones, nitro compounds, and sulfur compounds. The usage of the thermal polymerization inhibitor is preferably 0.001 to 2 wt%, and more preferably 0.005 to 1 wt% of the photosensitive resin composition. As to these compounds, not only a single compound, but also a mixture of two or more compounds can be used.

The photosensitive resin layer preferably has a thickness of 0.1 to 10 mm. When the thickness is less than 0.1 mm, the relief depth necessary for the use as a printing plate material may not be obtained. When the thickness is more than 10 mm, the weight of the printing plate material is heavy and inconvenience may possibly be caused in practical handling.

The photosensitive resin composition can be molded into a photosensitive resin layer by a melt molding method, or any known method such as hot pressing, cast molding, melt extrusion, and solution casting.

A photosensitive resin plate precursor as the relief printing plate precursor can be produced by stacking the photosensitive resin layer, which has been molded in the shape of a sheet, on the support with the adhesive layer interposed between the photosensitive resin layer and the support. That is, the photosensitive resin plate precursor has a structure comprising the support and the photosensitive resin layer stacked on one another. When a laminate obtained by stacking, on the support, the photosensitive resin layer having a sheet shape is supplied, a protective layer (cover film) is preferably further stacked on the photosensitive resin layer. In this case, the photosensitive resin plate precursor has a structure comprising the support, the photosensitive resin layer, and the protective layer stacked in this order. Used as the protective layer is one obtained by applying, in a thickness of 1 to 3 µm, a polymer compound which is nonadhesive and transparent and is capable of being dispersed or dissolved in a developer, to a plastic film, e.g., a 125-µm-thick polyester film. Disposing, on the photosensitive resin layer, this protective layer having a thin polymer coating can facilitate peeling of the protective layer to be performed at the time of exposure operation, even when the surface adhesiveness of the photosensitive resin layer is high.

By disposing a thermosensitive mask layer on a surface of the photosensitive resin layer, the relief printing plate precursor can be produced into a CTP (Computer To Plate) plate that needs no use of a negative film. As to the thermosensitive mask layer, a known thermosensitive mask layer can be used.

The relief printing plate precursor is exposed by overlaying a negative film having a transparent image portion on the photosensitive resin layer obtained from the photosensitive resin composition so as to closely attach the negative film to the photosensitive resin layer, and applying an active light beam from the above of the negative film. Thereby, a plate precursor having an exposed portion which the active light beam has reached and is thus made insoluble is produced. Used for the active light beam is a light source such as a high-pressure mercury lamp normally having a main wavelength of 300 to 450 nm, a super high-pressure mercury lamp, a metal halide lamp, a xenon lamp, and a chemical lamp. On the other hand, in the cases of the CTP plate, light is, in an image-wise pattern, applied by an IR laser to the thermosensitive mask layer so as to form a mask (having the same function as the negative film) on the photosensitive resin layer. After writing image information on the thermosensitive mask layer, an active light beam is applied onto the whole surface of the photosensitive printing plate precursor through the mask so as to produce a plate precursor having an exposed portion which the active light beam has reached and is thus made insoluble.

Next, an uncured portion is dissolved and removed with an appropriate solvent, particularly neutral water in the present disclosure. Specifically, the uncured portion can be dissolved and removed by a developing system such as a spray developing device and a brush developing device. Thereafter, the printing plate obtained by dissolving and removing the uncured portion is subjected to draining off of water, drying, and a post exposure step so as to give a final printing plate.

### Examples

The effects exhibited by using the photosensitive resin composition according to the present invention are indicated by way of the following examples. The present invention, however, is not limited to these examples. The parts used in Examples mean the parts by weight. The numerical values representing the compositional proportion in a table also mean the parts by weight.

### (Production of polymer compound 1)

ε-Caprolactam (396 parts), adipic acid (469 parts), 1,4-bis(3-aminopropyl)piperazine (341 parts), 1,3-bis(aminomethyl)cyclohexane (199 parts), isophoronediamine (34 parts), a 50% aqueous solution of hypophosphorous acid (5 parts), and water (1000 parts) were charged into an autoclave. After nitrogen substitution, the autoclave was hermetically sealed and gradually heated. Water was distilled out from the time point at which the inner pressure reached 0.4 MPa until the inner pressure was no longer maintained. The inner pressure was returned to an ordinary pressure in about 2 hours, and thereafter, a reaction was performed at an ordinary pressure for 1 hour. The highest polymerization reaction temperature was 255°C. Thereby, a polyamide was obtained. The composition of the polyamide was measured by H-NMR, and no difference was confirmed between the charging composition and the polymer composition.

### (Production of polymer compound 2)

Two equivalents (672.8 parts) of hexamethylene diisocyanate were put in a flask equipped with a dropping funnel and heated to 110°C in a nitrogen atmosphere. Then, 1 equivalent (1200.0 parts) of polyethylene glycol having a number average molecular weight of 600 was, with the dropping funnel, dropped thereto under stirring. The stirring was continued for 30 min after the dropping. In the obtained compound, the amount of the isocyanate was half the original amount. The hydroxy groups at both terminals of the polyethylene glycol were reacted with isocyanate groups, and thus, a PEG600-both terminal-HDI-modified product having isocyanate groups at both terminals was obtained.

Adipic acid (219 parts), 1,4-cyclohexanedicarboxylic acid (400 parts), 2-methyl pentamethylenediamine (139 parts), 1,4-bis(3-aminopropyl)piperazine (320 parts), isophoronediamine (210 parts), a 50% aqueous solution of hypophosphorous acid (5 parts), and water (1000 parts) were charged into an autoclave. After nitrogen substitution, the autoclave was hermetically sealed and gradually heated. Water was distilled out from the time point at which the inner pressure reached 0.4 MPa until the inner pressure was no longer maintained. The inner pressure was returned to an ordinary pressure in about 2 hours, and thereafter, a reaction was performed at an ordinary pressure for 1 hour. The highest polymerization reaction temperature was 255°C. Thereby, a polyamide was obtained.

Next, the obtained polyamide (1288 parts) and α,ω-diaminopolypropylene (120 parts) were dissolved in methanol (1690 parts). The α,ω-diaminopolypropylene had been obtained by addition of acrylonitrile to both terminals of polypropylene glycol having a number average molecular weight of 400 and hydrogen reduction of the addition product. Subsequently, the PEG600-HDI-modified product (656 parts) was gradually added under stirring of the mixture, which was reacted for about 45 min. This solution was placed on a petri dish coated with Teflon (registered trade name), had the methanol evaporated and thus removed therefrom, and was then dried under reduced pressure so as to give a polymer compound. The composition of the polyamide was measured by H-NMR, and no difference was confirmed between the charging composition and the polymer composition.

By obtaining polymer compounds 3, 4, and 5 through polymerization by similar method, polymer compounds 1 to 5 that were polyamides and/or polyamide block copolymers were obtained. However, the types and the blending proportion of the raw materials were changed as shown in Table 1.

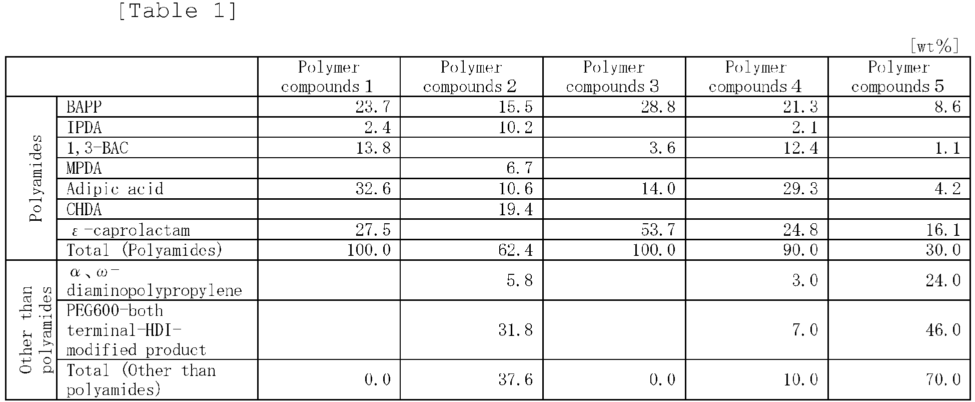

### (Preparation of support)

Dihydrothio-p-toluidine (0.5 parts) as an ultraviolet absorber was dissolved in dimethylamino acetamide (3.6 parts), and "VYLON 30SS" (product of TOYOBO Co., Ltd., concentration of solid content 30%, molecular weight 20000 to 25000) (100 parts) as a polyester resin solution, and "U-CAT SA102" (product of San-Apro Ltd., DBU-octylate composition) (0.2 parts) as a catalyst were dissolved in dioxane (0.7 parts) and mixed. Next, "Coronate L" (product of Nippon Polyurethane Industry Co., Ltd.) (10.2 parts) as a polyfunctional isocyanate was dissolved in ethyl acetate (1.4 parts) and mixed so as to give a solution of an adhesive composition. This solution was uniformly applied to a 188-µm-thick transparent polyester film support, and dried by 120°C hot-air dryer for 1 minute so as to give a support provided with a transparent adhesive layer having a 20-µm coating film.

### (Preparation of cover film)

By coating a surface of a 125-µm polyester film with a 2-µm-thick partially saponified Poval (48-80, manufactured by Kuraray Co., Ltd.) coating, a cover film having the polyester film coated with the partially saponified Poval was produced.

### [Example 1]

### (Preparation of photosensitive resin plate)

A polyamide resin (55.0 parts) as the polymer compound 1 was added to a mixture of methanol (62 parts) and water (10 parts), and heated at 65°C and dissolved. Then, diethylene glycol (5.0 parts), lactic acid (5.0 parts) as a quaternizing agent, and hydroquinone monomethyl ether (0.1 parts) were added, and further stirred for 30 minutes and dissolved, and the polyamide was made into an ammonium salt and was thus made water-soluble. Thereafter, glycidyl methacrylate (GMA) (2.5 parts), benzyl dimethyl ketal (1.0 part) as a photopolymerization initiator, glycerin dimethacrylate (Light Ester G101P manufactured by kyoeisha Chemical Co., Ltd.) (12 parts), 2-hydroxy-3-acryloyloxypropyl methacrylate (Light Ester G201P manufactured by kyoeisha Chemical Co., Ltd.) (14.5 parts), and polyglycerin #500 (5.0 parts) were added, and stirred for 30 minutes and dissolved. Next, the mixture was gradually heated so as to distill out the methanol and the water, and was concentrated until the temperature in the kettle became 110°C. In this stage, a flowable and viscous photosensitive resin composition was obtained. This photosensitive composition was cast on the 250-µm polyethylene terephthalate film as a support. The 250-µm polyethylene terephthalate film had the surface thereof coated at 20 µm with the adhesive composition containing the ultraviolet absorber. The cover film having the 2-µm stack of the partially saponified Poval having a saponification degree of 79.5 mol% was placed in contact with the photosensitive resin composition cast on the 250-µm polyethylene terephthalate film, and a photosensitive resin plate precursor (relief printing plate precursor), which was a sheet-shaped laminate having a total thickness of 1080 µm, was formed using a laminator.

### [Examples 2 to 13, Comparative Examples 1 to 3]

Similarly to Example 1, photosensitive resin plate precursors (relief printing plate precursors), which were sheet-shaped laminates having a total thickness of 1080 µm, were formed. Table 2 shows the composition thereof. Hereinafter, the photosensitive resin plate precursor is also referred to as a raw plate.
R-PG: Manufactured by Sakamoto Yakuhin Kogyo Co., Ltd., Polyglycerin, number average molecular weight 240 Polyglycerin #500: Manufactured by Sakamoto Yakuhin Kogyo
Co., Ltd., Polyglycerin, number average molecular weight 500
SC-E350: Manufactured by Sakamoto Yakuhin Kogyo Co., Ltd., POE(4)Polyglyceryl ether, number average molecular weight 350
SC-E1500: Manufactured by Sakamoto Yakuhin Kogyo Co., Ltd., POE(30)Polyglyceryl ether, number average molecular weight 1500
SC-P750: Manufactured by Sakamoto Yakuhin Kogyo Co., Ltd., POP(9)Polyglyceryl ether, number average molecular weight 750
Epoxy ester 70PA: Manufactured by kyoeisha Chemical Co., Ltd., Propylene glycol diglycidyl ether acrylic acid addition product

**[Table 2]**

| [wt%] | | | | | | | | | |
|---|---|---|---|---|---|---|---|---|---|
| | | Example 1 | Example 2 | Example 3 | Example 4 | Example 5 | Example 6 | Example 7 | Example 8 |
| Polymer | Polymer compounds 1 | 55 | 55 | 55 | 55 | 55 | 55 | 55 | |
| | Polymer compounds 2 | | | | | | | | 50 |
| | Polymer compounds 3 | | | | | | | | |
| | Polymer compounds 4 | | | | | | | | |
| | Polymer compounds 5 | | | | | | | | |
| Plasticizer | Diethylene glycol | 5 | 1 | 0 | 1 | 1 | 5 | 0 | 5 |
| Polyglycerin | R-PG | | | | | | | | |
| | Polyglycerin # 500 | 5 | 9 | 13 | | | | | 13 |
| Polyglycerin derivative | SC-E350 | | | | 9 | | 5 | | |
| | SC-E1500 | | | | | 9 | | 13 | |
| | SC-P750 | | | | | | | | |
| Acid | Lactic acid | 5 | 5 | 5 | 5 | 5 | 5 | 5 | 5 |
| Crosslinking agent | GMA | 2.5 | 2.5 | 2.5 | 2.5 | 2.5 | 2.5 | 2. 5 | 2.5 |
| | G101P | 12 | 12 | 12 | 12 | 12 | 12 | 12 | |
| | G201P | 14. 5 | 14.5 | 11.5 | 14. 5 | 14.5 | 14.5 | 11.5 | |
| | Epoxy ester 70PA | | | | | | | | 23. 5 |
| Photopolymerization initiator | Benzyl dimethyl ketal | 1 | 1 | 1 | 1 | 1 | 1 | 1 | 1 |
| | Total | 100 | 100 | 100 | 100 | 100 | 100 | 100 | 100 |

| | | | | | | | | | |
|---|---|---|---|---|---|---|---|---|---|
| R-PG: Manufactured by Sakamoto Yakuhin Kogyo Co., Ltd., Polyglycerin, number average molecular weight 240 Polyglycerin #500: Manufactured by Sakamoto Yakuhin Kogyo Co., Ltd., Polyglycerin, number average molecular weight 500 SC-E350: Manufactured by Sakamoto Yakuhin Kogyo Co., Ltd., POE(4)Polyglyceryl ether, number average molecular weight 350 SC-E1500: Manufactured by Sakamoto Yakuhin Kogyo Co., Ltd., POE(30)Polyglyceryl ether, number average molecular weight 1500 SC-P750: Manufactured by Sakamoto Yakuhin Kogyo Co., Ltd., POP(9)Polyglyceryl ether, number average molecular weight 750 70PA: Manufactured by kyoeisha Chemical Co., Ltd., Propylene glycol diglycidyl ether acrylic acid addition product | | | | | | | | | |

[wt%]

| | | Example 9 | Example 10 | Example 11 | Example 12 | Example 13 | Comparative Example 1 | Comparative Example 2 | Comparative Example 3 |
|---|---|---|---|---|---|---|---|---|---|
| Polymer | Polymer compounds 1 | | | | | 55 | 55 | 50 | 55 |
| | Polymer compounds 2 | | | | | | | | |
| | Polymer compounds 3 | 45 | | | | | | | |
| | Polymer compounds 4 | | 55 | 50 | | | | | |
| | Polymer compounds 5 | | | | 55 | | | | |
| Plasticizer | Diethylene glycol | 5 | 5 | 5 | 5 | 5 | 10 | 9 | 0 |
| Polyglycerin | R-PG | | | | | 5 | | | |
| | Polyglycerin # 500 | | | | 5 | | | 20 | 20 |
| Polyglycerin derivative | SC-E350 | 5 | | | | | | | |
| | SC-E1500 | | 8 | | | | | | |
| | SC-P750 | | | 13 | | | | | |
| Acid | Lactic acid | 5 | 5 | 5 | 5 | 5 | 5 | 5 | 5 |
| Crosslinking agent | GMA | 2.5 | 2.5 | 2.5 | 2.5 | 2.5 | 2.5 | 2. 5 | 2.5 |
| | G101P | 12 | | | 12 | 12 | 12 | | 12 |
| | G201P | 14. 5 | | | 14.5 | 14.5 | 14.5 | 12. 5 | 4. 5 |
| | Epoxy ester 70PA | 10 | 22. 5 | 22.5 | | | | | |
| Photopolymerization initiator | Benzyl dimethyl ketal | 1 | 2 | 2 | 1 | 1 | 1 | 1 | 1 |
| | Total | 100 | 100 | 100 | 100 | 100 | 100 | 100 | 100 |

| | | | | | | | | | |
|---|---|---|---|---|---|---|---|---|---|
| R-PG: Manufactured by Sakamoto Yakuhin Kogyo Co., Ltd., Polyglycerin, number average molecular weight 240 Polyglycerin #500: Manufactured by Sakamoto Yakuhin Kogyo Co., Ltd., Polyglycerin, number average molecular weight 500 SC-E350: Manufactured by Sakamoto Yakuhin Kogyo Co., Ltd., POE(4)Polyglyceryl ether, number average molecular weight 350 SC-E1500: Manufactured by Sakamoto Yakuhin Kogyo Co., Ltd., POE(30)Polyglyceryl ether, number average molecular weight 1500 SC-P750: Manufactured by Sakamoto Yakuhin Kogyo Co., Ltd., POP(9)Polyglyceryl ether, number average molecular weight 750 70PA: Manufactured by kyoeisha Chemical Co., Ltd., Propylene glycol diglycidyl ether acrylic acid addition product | | | | | | | | | |

The reproducibility and the developability after the storage of the raw plate in a high-temperature environment and the wound-around performance and the surface layer of the resin relief printing plate (printing plate) stored in a low-temperature environment were evaluated. Table 3 shows these results.

**[Table 3]**

| | | Example 1 | Example 2 | Example 3 | Example 4 | Example 5 | Example 6 | Example 7 | Example 8 |
|---|---|---|---|---|---|---|---|---|---|
| Reproducibility | 22°C, 50%RH storage | ○ | ○ | ○ | ○ | ○ | ○ | ○ | ○ |
| | 50°C, 35%RH storage | ○ | ○ | ○ | ○ | ○ | ○ | ○ | ○ |
| Developability | 22°C,50%RH storage | 2 min 15 second | 2 min 20 second | 2 min 20 second | 2 min 15 second | 2 min 20 second | 2 min 00 second | 2 min 20 second | 2 min 00 second |
| | 50°C,35%RH storage | 2 min 45 second | 2 min 45 second | 2 min 40 second | 2 min 45 second | 2 min 40 second | 3 min 00 second | 2 min 35 second | 3 min 00 second |
| | Difference | 30 second ○ | 25 second ○ | 20 second ○ | 30 second ○ | 20 second ○ | 1 min ○ | 15 second O | 1 min ○ |
| Wound-around performance | 22°C,50%RH storage | ○ | ○ | ○ | ○ | ○ | ○ | ○ | ○ |
| | 5°C, 10%RH storage | ○ | ○ | ○ | ○ | ○ | ○ | ○ | ○ |
| Surface layer after wound | 22°C, 50%RH storage | ○ | ○ | ○ | ○ | ○ | ○ | ○ | ○ |
| | 5°C, 10%RH storage | ○ | ○ | ○ | ○ | ○ | ○ | ○ | ○ |

| | | Example 9 | Example 10 | Example 11 | Example 12 | Example 13 | Comparative Example1 | Comparative Example2 | Comparative Example3 |
|---|---|---|---|---|---|---|---|---|---|
| Reproducibility | 22°C,50%RH storage | ○ | ○ | ○ | ○ | ○ | ○ | Δ | Δ |
| | 50°C,35%RH storage | ○ | ○ | ○ | Δ | ○ | ○ | × | × |
| Developability | 22°C,50%RH storage | 2min00 second | 2 min 45 second | 2 min 00 second | 1 min 30 second | 2 min 00 second | 2 min 00 second | 1 min 30 second | 2 min 25 second |
| | 50°C, 35%RH storage | 2 min 30 second | 3 min 30 second | 2 min 30 second | 2 min 00 second | 3 min 15 second | 4 min 30 second | 2 min 00 second | 2 min 35 second |
| | Difference | 30 second ○ | 45 second ○ | 30 second ○ | 30 second ○ | 1 min 15 second Δ | 2 min 30 second × | 30 second ○ | 10 second O |
| Wound-around performance | 22°C,50%RH storage | ○ | ○ | ○ | ○ | ○ | ○ | ○ | ○ |
| | 5°C, 10%RH storage | ○ | ○ | ○ | ○ | Δ | × | ○ | ○ |
| Surface layer after wound | 22°C,50%RH storage | ○ | ○ | ○ | ○ | ○ | ○ | ○ | ○ |
| | 5C, 10%RH storage | ○ | ○ | ○ | ○ | ○ | × | ○ | ○ |

Here, the step of making a resin relief printing plate used for the evaluation (plate-making step) is described.

Using a printing evaluation negative film having an image with 2% to 95% dots at 150 lines, minimum independent dots having diameters of 200 to 600 µm, minimum independent lines having widths of 60 to 150 µm, and a solid image (width 1 cm × length 5 cm), ultraviolet light was applied to the raw plate having the cover film peeled therefrom at a height distance of 5 cm from a surface of the photosensitive resin, using a chemical lamp having the illuminance thereof adjusted to 3.4 mW/cm², and setting, as the optimal exposing time, a minimum exposing time necessary for reproducing 2% dots at 150 lines. Next, the raw plate was developed using a brush washer (120 µmφ nylon brush, JW-A2-PD type manufactured by Nihon Denshi Seiki Co., Ltd.), with 25°C tap water so as to give a relief image. Further, hot-air drying was performed at 60°C for 10 min, then ultraviolet light was post-applied for 30 s with a super high-pressure mercury lamp, and a 15-cm square resin relief printing plate was thus obtained.

### (1) Evaluation of reproducibility and developability after storage in high-temperature environment

The raw plate stored in an environment at a temperature of 22°C and a humidity of 50% for 60 days and the raw plate stored in high-temperature environment at a temperature of 50°C and a humidity of 35% for 60 days were evaluated.

### (Reproducibility)

The reproducibility was evaluated by evaluating the reproducibility of the minimum independent dots and the minimum independent lines of the resin relief printing plate developed by exposure with the optimal exposing time. A 10-power loupe was used for the evaluation, and the determination was thus made by the naked eye.
∘: Both the independent dots having a diameter of 200 µm and the independent lines having a line width of 60 µm were reproduced.
Δ: Only either the independent dots having a diameter of 200 µm or the independent lines having a line width of 60 µm were reproduced.
×: Neither the independent dots having a diameter of 200 µm nor the independent lines having a line width of 60 µm were reproduced.

### (Evaluation of developability)

The developability was evaluated by the difference of the developing time in the plate-making step between the raw plates respectively stored in the two environments described above. Here, the developing time is the time taken for completely washing away the photosensitive resin composition which has not been cured through the photoreaction by the application of ultraviolet light through the negative film.
o: The difference of the developing time between the two environments was 1 min or less.
Δ: The difference of the developing time between the two environments was more than 1 min but 2 min or less.
×: The difference of the developing time between the two environments was more than 2 min.

### (2) Evaluation of wound-around performance and surface layer after storage in low-temperature environment

The resin relief printing plates made in the plate-making step were stored for 24 hours respectively in an environment at a temperature of 22°C and a humidity of 50% and in a low-temperature environment at a temperature of 5°C and a humidity of 10%. Thereafter, the made printing plate was attached, from the film side thereof, to a 9-cm-diameter cylinder having a double-sided tape attached to the side surface thereof, and the wound-around performance and the surface layer were evaluated. The evaluation of the surface layer was determined by the naked eye using a 10-power loupe.

### (Evaluation of wound-around performance)

∘: Maintained without being peeled for 30 min
Δ: Partially peeled in less than 30 min
×: Impossible to be wound around

### (State of surface layer)

∘: The printing plate did not cause any crack and chipping.
×: The printing plate caused a crack and chipping.

As shown in Table 3, all the examples were understood to each have high-level or acceptable-level performance such as reproducibility, developability, and wound-around property. The performance is more specifically described as follows.

Examples 1 to 3 were prepared by differentiating the content of polyglycerin (which hereinafter can also be simply referred to as polyglycerin content) in the photosensitive resin composition. The polyglycerin content is 5 wt% in Example 1, 9 wt% in Example 2, and 13 wt% in Example 3. All of Examples 1 to 3 are high-level in all the reproducibility, the developability, and the wound-around property. In Examples 4 and 5, the photosensitive resin composition contained a polyglycerin derivative instead of polyglycerin. In Examples 4 and 5, the content of the polyglycerin derivative (which hereinafter can also be simply referred to as polyglycerin derivative content) in the photosensitive resin composition is 9 wt% which is the same content as polyglycerin in Example 2. In Example 4, the number average molecular weight of the polyglycerin derivative in the photosensitive resin composition is 350 which is less than the number average molecular weight of polyglycerin in Example 2. In Example 5, the number average molecular weight of the polyglycerin derivative in the photosensitive resin composition is 1500 which is more than the number average molecular weight of polyglycerin in Example 2. Both Examples 4 and 5 are high-level in all the reproducibility, the developability, and the wound-around property. Example 6 was prepared similarly to Example 4, but by reducing the content of the polyglycerin derivative in the photosensitive resin composition from 9 wt% to 5 wt%. Example 7 was prepared similarly to Example 5, but by increasing the content of the polyglycerin derivative in the photosensitive resin composition from 9 wt% to 13 wt%. Both Examples 6 and 7 are high-level in all the reproducibility, the developability, and the wound-around property.

Examples 8 to 12 were prepared by replacing the polymer compound 1 in the photosensitive resin composition with other polymer compounds. In Example 8, the polymer compound 2 was used. In Example 9, the polymer compound 3 was used. In Examples 10 and 11, the polymer compound 4 was used. In Example 12, the polymer compound 5 was used. All Examples 8 to 11 are high-level in all the reproducibility, the developability, and the wound-around property. Example 12 has acceptable-level of reproducibility, and high-level of developability and wound-around property. Example 13 was prepared similarly to Example 1, but by changing the polyglycerin to be contained in the photosensitive resin composition, from one having a number average molecular weight of 500, to one having a number average molecular weight of 240. Example 13 has high-level of reproducibility, but is evaluated as having acceptable-level as to developability and wound-around property.

Comparative Example 1 was prepared similarly to Example 1, but by adding no polyglycerin to the photosensitive resin composition. Comparative Example 1 has high-level of reproducibility, but is evaluated as poorer than the examples as to the developability and the wound-around property. Comparative Examples 2 and 3 were prepared similarly to Example 1, but by increasing the polyglycerin content to 20 wt% which was more than the polyglycerin content in Example 3. Both Comparative Examples 2 and 3 have high-level of developability and wound-around property, but are evaluated as poorer than the examples as to the reproducibility.

## Claims

1. A photosensitive resin composition for a relief printing plate precursor, wherein the photosensitive resin composition contains: a polyamide and/or a polyamide block copolymer (a); a crosslinking agent (b) having one or more unsaturated groups; a photopolymerization initiator (c); and polyglycerin and/or a polyglycerin derivative (d), wherein the polyglycerin derivative is obtained by addition polymerization of polyglycerin with ethylene oxide or propylene oxide, and wherein a content of (d) in the photosensitive resin composition is 3 to 15 wt%.

2. The photosensitive resin composition for a relief printing plate precursor according to claim 1, wherein the polyglycerin and the polyglycerin derivative (d) each have a number average molecular weight of 300 or more.

3. The photosensitive resin composition for a relief printing plate precursor according to claim 1, wherein the photosensitive resin composition contains the polyglycerin derivative (d), and wherein the polyglycerin derivative (d) is polyoxyethylene polyglyceryl ether and/or polyoxypropylene polyglyceryl ether having a number average molecular weight of 300 or more.

4. The photosensitive resin composition for a relief printing plate precursor according to claim 1, wherein the photosensitive resin composition contains: 40 to 60 wt% of the polyamide and/or the polyamide block copolymer (a); 20 to 50 wt% of the crosslinking agent (b) having one or more unsaturated groups; and 0.1 to 10 wt% of the photopolymerization initiator (c), and wherein the polyamide and/or the polyamide block copolymer (a) contains, in a molecule thereof, 20 wt% or more of blocks of structural units each containing an amide bond.

5. A relief printing plate precursor obtained by stacking, on a support, a photosensitive resin layer made from the photosensitive resin composition for a relief printing plate precursor according to any of claims 1 to 4.

6. A printing plate obtained by removing an uncured portion of the photosensitive resin layer from the relief printing plate precursor according to claim 5.
